(19) Europäisches Patentamt
European Patent Office
Office européen des brevets

(11) **EP 4 734 365 A1**

(12) **EUROPEAN PATENT APPLICATION**

(43) Date of publication:
**29.04.2026 Bulletin 2026/18**

(21) Application number: **24208762.5**

(22) Date of filing: **24.10.2024**

(51) International Patent Classification (IPC):
$H03F\ 3/19^{(2006.01)}$  $H03F\ 3/24^{(2006.01)}$
$H03F\ 1/22^{(2006.01)}$  $G05F\ 3/26^{(2006.01)}$
$H03F\ 3/45^{(2006.01)}$

(52) Cooperative Patent Classification (CPC):
**H03F 3/19; G05F 3/26; H03F 1/22; H03F 3/245;
H03F 3/4578;** H03F 2203/21127; H03F 2203/45398

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP B.V.
5656 AG Eindhoven (NL)**

(72) Inventors:
• **JANSSON,, Lars Gustaf
5656 AG Eindhoven (NL)**

• **YANG,, Xin
5656 AG Eindhoven (NL)**
• **DAHLIN,, Jan Gunnar
5656 AG Eindhoven (NL)**
• **HEDENÄS,, Charlotta Maria
5656 AG Eindhoven (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **A BIAS CIRCUIT**

(57) A bias circuit configured to provide a differential voltage and a common-mode voltage. The bias circuit includes a differential circuit and a common-mode circuit. The differential circuit includes a first differential input resistor, a first differential output resistor, a second differential output resistor, and a second differential input resistor connected together in series, in that order, between first and second differential input terminals. A first differential output terminal is connected to a node between the first differential input resistor and the first differential output resistor; and a second differential output terminal is connected to a node between the second differential output resistor and the second differential input resistor. The common-mode circuit includes: a common-mode transistor has a conduction channel connected in series between: i) the node between the first differential output resistor and the second differential output resistor; and ii) a reference terminal; a common-mode resistor connected between: i) the node between the first differential output resistor and the second differential output resistor; and ii) a control terminal of the common-mode transistor; and a common-mode current source connected between the control terminal of the common-mode transistor and the reference terminal.

Figure 1

EP 4 734 365 A1

## Description

### Field

The present disclosure relates to bias circuits, and especially to bias circuits that can provide both a differential voltage and a common-mode voltage.

### Summary

According to a first aspect of the present disclosure there is provided a bias circuit configured to provide a differential voltage and a common-mode voltage, the bias circuit comprising:

a first differential output terminal and a second differential output terminal, configured to provide the differential voltage therebetween;
a common-mode output terminal, configured to provide the common-mode voltage;
a differential circuit comprising:

a first differential input terminal and a second differential input terminal, configured to receive a differential current therebetween;
a first differential input resistor, a first differential output resistor, a second differential output resistor, and a second differential input resistor connected together in series, in that order, between the first differential input terminal and the second differential input terminal; wherein: i) the first differential output terminal is connected to a node between the first differential input resistor and the first differential output resistor; and the second differential output terminal is connected to a node between the second differential output resistor and the second differential input resistor;

a common-mode circuit comprising:

a common-mode biasing terminal that is connected to a node between the first differential output resistor and the second differential output resistor, wherein the common-mode biasing terminal is configured to receive a common-mode bias current;
a common-mode transistor comprising:

a conduction channel that is connected in series between:

i) the node between the first differential output resistor and the second differential output resistor; and ii) a reference terminal; and

a control terminal;

a common-mode resistor that is connected between: i) the node between the first differential output resistor and the second differential output resistor; and ii) the control terminal of the common-mode transistor; and
a common-mode current source connected between the control terminal of the common-mode transistor and the reference terminal;

wherein the common-mode output terminal is connected to the node between the first differential output resistor and the second differential output resistor.

Advantageously, such a bias circuit can be used to set the common-mode voltage and the differential voltage independently of each other.

In one or more embodiments, the resistance levels of the first differential output resistor and the second differential output resistor are configurable in order to set the differential voltage between the first and second differential output terminals. This can be without affecting the common-mode voltage at the common-mode output terminal.

In one or more embodiments, the resistance level of the common-mode resistor is configurable in order to set the common-mode voltage at the common-mode output terminal. This can be without affecting the differential voltage between the first and second differential output terminals.

In one or more embodiments, the common-mode current source is configurable such that it provides a common-mode current in order to set the common-mode voltage at the common-mode output terminal. This can be without affecting the differential voltage between the first and second differential output terminals.

In one or more embodiments, the common-mode current source provides the common-mode current at a level that is based on a common-mode temperature coefficient.

In one or more embodiments, the bias circuit further comprises: a reference current generator circuit, configured to: receive the common-mode temperature coefficient and provide the common-mode current based on the received common-mode temperature coefficient.

In one or more embodiments, the current source comprises a current mirror, wherein the current mirror receives a common-mode reference current as an input signal and provides the common-mode current as an output signal.

In one or more embodiments, the bias circuit further comprises:

a reference current generator circuit, configured to:
receive the common-mode temperature coefficient and provide the common-mode reference current based on the received common-mode temperature coefficient.

In one or more embodiments, the bias circuit further comprises a differential current source that is configured to provide the differential current at a level that is based on a differential temperature coefficient.

In one or more embodiments, the bias circuit further comprises:

a reference current generator circuit, configured to:
receive the differential temperature coefficient and provide the differential current to the first and second differential input terminals based on the received differential temperature coefficient.

In one or more embodiments, the common-mode transistor is a bipolar transistor.

There is also disclosed a multi-channel amplifier circuit, comprising:

a plurality of channel circuits, wherein each channel circuit comprises: any bias circuit disclosed herein; and

one or more amplifiers, wherein the one or more amplifiers are configured to receive the differential voltage and the common-mode voltage from the associated bias circuit.

In one or more embodiments, the common-mode current source provides a common-mode current at a level that is based on a common-mode temperature coefficient.

In one or more embodiments, the multi-channel amplifier circuit further comprises:

a differential current source that is configured to provide the differential current to the first and second differential input terminals at a level that is based on a differential temperature coefficient; and / or

a temperature coefficient generator circuit that is configured to provide the common-mode temperature coefficient and the differential temperature coefficient to each of the plurality of channel circuits.

In one or more embodiments, the multi-channel amplifier circuit comprises a beamforming circuit. Each of the plurality of channel circuits may correspond to a different channel of the beamforming circuit.

In one or more embodiments, each of the channel circuits of the beamforming circuit comprises a transceiver circuit configured to transmit and / or receive signalling.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets.

The figures and Detailed Description that follow also exemplify various example embodiments. Various example embodiments may be more completely understood in consideration of the following Detailed Description in connection with the accompanying Drawings.

**Brief Description of the Drawings**

One or more embodiments will now be described by way of example only with reference to the accompanying drawings in which:

Figure 1 illustrates a bias circuit according to an embodiment of the present disclosure;
Figure 2 shows a top-level view of an integrated circuit (IC) according to an embodiment of the present disclosure; and
Figure 3 shows further details of a channel circuit according to an embodiment of the present disclosure.

**Detailed Description**

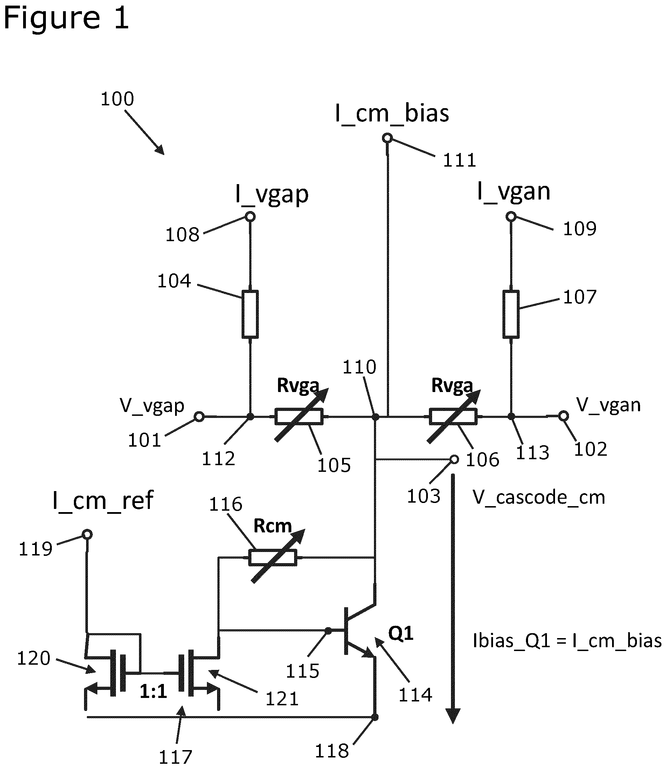

Figure 1 illustrates a bias circuit 100 according to an embodiment of the present disclosure. The bias circuit 100 provides both a differential voltage and a common-mode voltage. As will be discussed in detail below, the bias circuit can be considered as a universal bias circuit that can set the voltage levels of the differential voltage and the common-mode voltage independently of each other.

The bias circuit 100 includes a first differential output terminal 101 and a second differential output terminal 102, which provide the differential voltage therebetween. The first differential output terminal 101 is labelled as a positive differential output terminal in Figure 1 (V_vgap), and the second differential output terminal 102 is labelled as a negative differential output terminal in Figure 1 (V_vgan). The "vga" in these labels represents the suitability of the differential voltage for providing as an RF (radio frequency) voltage to a variable gain amplifier (VGA), as will be discussed below.

The bias circuit 100 also includes a common-mode output terminal 103, that provides the common-mode voltage. The common-mode voltage is labelled as V_cascode_cm in Figure 1, to represent the suitability of the common-mode voltage for providing as a DC voltage to a cascode circuit.

The bias circuit 100 includes a differential circuit, which has a first differential input terminal 108 and a second differential input terminal 109. The first differential input terminal 108 and the second differential input terminal 109 receive a differential current therebetween. The first differential input terminal 108 in Figure 1 is labelled as receiving a positive current (I_vgap) and the second differential input terminal 109 is labelled as receiving a negative current (I_vgan). This represents that, in this example, the instantaneous value of the current at the first differential input terminal 108 is the inverse of the instantaneous value of the current at the second differential input terminal 109.

The differential circuit also includes the following resistors, connected together in series in the order stated, between the first differential input terminal 108 and the second differential input terminal 109:

- a first differential input resistor 104,
- a first differential output resistor (Rvga) 105,
- a second differential output resistor (Rvga) 106, and
- a second differential input resistor 107.

As shown in Figure 1, the first differential output terminal 101 is connected to a node 112 between the first differential input resistor 104 and the first differential output resistor 105. As also shown in Figure 1. the second differential output terminal 102 is connected to a node 113 between the second differential output resistor 106 and the second differential input resistor 107. As will be discussed in detail below, the differential current is provided to the first and second differential input terminals 108, 109 in order to provide the required differential voltage across the first and second differential output terminals 101, 102. Furthermore, optionally the first and second differential output resistors (Rvga) 105, 106 can be provided as variable resistors (as shown in Figure 1) in order to define how the bias circuit 100 converts the level of the differential input current to the level of the differential output voltage.

The bias circuit 100 also includes a common-mode circuit. The common-mode circuit has a common-mode biasing terminal 111 and a common-mode transistor (Q1) 114. The common-mode biasing terminal 111 is connected to a node 110 between the first differential output resistor 105 and the second differential output resistor 106. The common-mode biasing terminal 111 is configured to receive a common-mode bias current (I_cm_bias).

The common-mode transistor 114 comprises a conduction channel and a control terminal 115. The conduction channel of the common-mode transistor 114 is connected in series between: i) the node 110 between the first differential output resistor 105 and the second differential output resistor 106; and ii) a reference terminal 118. In this example, the reference terminal 118 is a ground terminal. The common-mode transistor 114 in Figure 1 is a bipolar transistor such that the conduction channel extends between a collector terminal and an emitter terminal, and the control terminal 115 is a base terminal. However, in other examples the common-mode transistor 114 can be a MOSFET (metal oxide semiconductor field effect transistor). An advantage of using a bipolar transistor is that it has a relatively consistent value of Vbe (base-emitter voltage) over temperature.

The common-mode circuit also includes a common-mode resistor (Rcm) 116 and a common-mode current source 117. The common-mode resistor (Rcm) 116 is connected between: i) the node 110 between the first differential output resistor 105 and the second differential output resistor 106; and ii) the control terminal 115 of the common-mode transistor 114. The common-mode current source 117 is connected between the control terminal 115 of the common-mode transistor 114 and the reference terminal 118. The common-mode output terminal 103 is connected to the node 110 between the first differential output resistor 105 and the second differential output resistor 106.

As indicated above, the current signals received at the first and second differential input terminals 108, 109 (I_vgap and I_vga_n) in this example are complementary currents (that is, I_vgap+I_vga_n =0). This means that the current through the conduction channel of the common-mode transistor 114 (Ibias_Q1) equals the common-mode bias current (I_cm_bias). In this way, the common-mode bias current (I_cm_bias) biases a common-mode shunt feedback loop and can provide a base current for any cascodes that are connected to the common-mode output terminal 103 and / or a base current for any VGA transistors that are connected to the first and second differential output terminals 101, 102.

The impedance of the common-mode transistor 114 Z(cascode_cm), is defined by:

$$Z(cascode\_cm)=1/gm(Q1)\approx100\Omega$$

The common-mode voltage (V_cascode_cm) at the common-mode output terminal 103 equals the base-emitter voltage of the common-mode transistor 114 plus the voltage dropped across the common-mode resistor (Rcm) 116. That is:

$$V\_cascode\_cm = Vbe+I\_cm\_ref*Rcm$$

The current source 117 in this example comprises a current mirror. The current mirror receives a common-mode reference current (I_cm_ref) as an input signal and provides the common-mode current as an output signal. As shown in Figure 1, in this example the current mirror applies a 1:1 ratio between the common-mode reference current and the common-mode current.

The current mirror in the example of Figure 1 includes a reference current terminal 119 that receives the common-mode reference current (I_cm_ref). The current mirror also includes a first MOSFET 120 and a second MOSFET 121. The first MOSFET 120 has: a drain terminal that connected to the reference current terminal 119, a gate terminal that is connected to the reference current terminal 119, and a source terminal connected to the reference terminal 118. The second MOSFET 121 has: a drain terminal that is connected to the control terminal of the common-mode transistor 114, a gate terminal that is connected to the gate terminal of the first MOSFET 120, and a source terminal that is connected to the reference terminal 118.

The common-mode current source 117 is configurable such that it provides a common-mode current that has a current level in order to set the common-mode voltage (V_cascode_cm) at the common-mode output terminal 103, without affecting the differential voltage between the first and second differential output terminals 101, 102. In this way, advantageously, the bias circuit 100 can set the common-mode voltage (V_cascode_cm) independently of the differential voltage.

Furthermore, in this example the common-mode current source 117 provides the common-mode current at a level that is based on a common-mode temperature coefficient (TC2). In the implementation of Figure 1, in which the common-mode current source 117 is a current mirror, a reference current generator circuit (not shown) provides the common-mode reference current (I_cm_ref) based on a received common-mode temperature coefficient (TC2). More generally, any of the boas circuits disclosed herein can include a reference current generator circuit (not shown) that receives a common-mode temperature coefficient (TC2), directly or indirectly, and provides the common-mode current based on the received common-mode temperature coefficient (TC2).

In some examples, the common-mode bias current (I_cm_bias), and hence also the common-mode current, can be much greater than the common-mode reference current (I_cm_ref). That is, I_cm_bias >> I cm_ref. Keeping I_cm_ref relatively low is good for reducing power consumption.

The bias circuit 100 of Figure 1 can also include a differential current source (not shown) for providing the differential current (I_vgap and I_vgan) to the first and second differential input terminals 108, 109. Such a differential current source is configurable such that it provides the differential current (I_vgap and I_vgan) in order to set the differential voltage (V_vgap and V_vgan) at the first and second differential output terminals 101, 102, without affecting the common-mode voltage at the common-mode output terminal. In a similar way to that described above, this advantageously means that the bias circuit 100 can set the differential voltage independently of the common-mode voltage (V_cascode_cm).

In some examples, such a differential current source provides the differential current at a level that is based on a differential temperature coefficient (TC1). This can involve the bias circuit 100 including a reference current generator circuit (not shown) that receives the differential temperature coefficient (TC1) and provides the differential current (I_vgap and I_vgan) to the first and second differential input terminals 108, 109 based on the received differential temperature coefficient (TC1).

In the example of Figure 1, the first differential output resistor 105, the second differential output resistor 106 and the common-mode resistor 116 are variable resistors. Although in other examples only some, or none, of these resistors are variable resistors. The resistance levels of these variable resistors can be set in order to configure the common-mode and or differential voltage levels that are provided as output signals by the bias circuit 100. The intention with Figure 1 is not to dynamically adjust the resistance levels of the variable resistors during use; instead it is to configure the bias circuit 100 before it is used such that it provides output voltage signals at the required level.

More particularly, the resistance levels of the first differential output resistor 105 and the second differential output resistor 106 are configurable in order to set the differential voltage between the first and second differential output terminals 101, 102. Advantageously, due to the circuit layout, the resistance levels of these differential output resistors 105, 106 can be set without affecting the common-mode voltage at the common-mode output terminal 103.

In addition, the resistance level of the common-mode resistor 116 is configurable in order to set the common-mode voltage at the common-mode output terminal 103. Again, advantageously, due to the circuit layout, the resistance level of this variable resistor can be set without affecting the differential voltage between the first and second differential output terminals 101, 102.

The bias circuit 100 of Figure 1 can be considered as a universal cell that is particularly well-suited to provide a cascode / VGA bias for bipolar RF CE / CB cascode amplifiers (where RF stands for radio frequency, CE stands for common-emitter and CB stands for common-base). As will be appreciated from the above description:

- The universal cell can be customized with a minor resistor change;
- The universal cell can be used for a cascode amplifier or a VGA;
- The cascode can be easily programmable with a reference current;
- The cascode voltage CM (common-mode) voltage is independent from the differential VGA voltage (when used for VGA);
- The cascode voltage can easily be adjusted with a resistor change. The value can then be adjusted by changing a reference current with an IDAC (current digital-to-analogue converter) control by a digital word.
- The temperature behavior can be changed and optimized with the reference current.
- The shunt feedback setup (as provided by the configuration of the common-mode transistor 114) can allow for lowest possible DC impedance to ground of one diode (1/gm). This can be important to control the breakdown of the cascode transistor.
- The same circuit can be configured to bias a VGA. The VGA voltage range and temperature is independent from the CM voltage.

The above functionality can be especially useful when the bias circuit 100 is used to provide bias voltages to a plurality of RF Amplifiers, which all use the same basic bipolar CB-CE stage (Cascoded Amplifier). In this way, a universal cell is provided that can be used for all RF amplifiers. This can beneficially save layout time and reduce risk of errors in the circuit design. In addition, all RF amplifiers can have the same type of digital control to simplify the set-up of the design - both in the laboratory and in the end-use application.

In addition, the bias circuit 100 can be considered as having a DC part and an RF part. The DC part can be located independently from the RF part to make floor planning easier. In addition, the RF part can be placed in the signal path inside an RF amplifier. Common blocks can be used that are easy to customize for each RF amplifier.

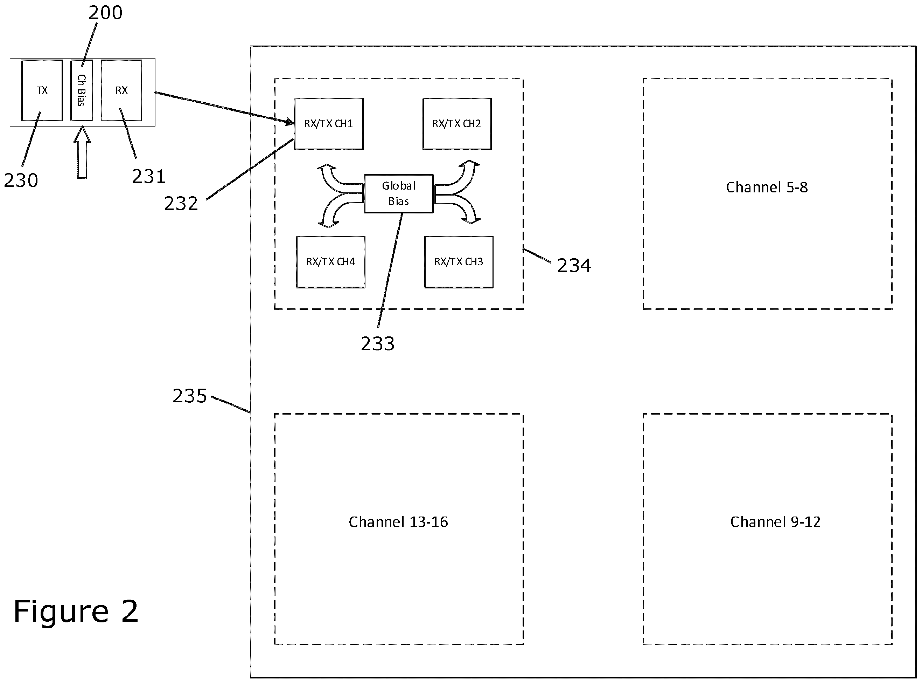

Figure 2 shows a top-level view of an integrated circuit (IC) 235 according to an embodiment of the present disclosure. In this example, the IC 235 is a beamforming IC that includes a plurality of channel circuits 232, whereby each channel circuit includes a transceiver circuit configured to transmit and / or receive signalling, as is known in the art. In beamforming ICs, the space available on the IC can be particularly limited due to the wavelength of the RF signals that are processed.

The IC 235 includes four multi-channel amplifier circuits 234. Each of the multi-channel amplifier circuits 234 includes four channel circuits 232 such that, overall, the IC 235 has sixteen channels.

Each channel circuit 232 includes a bias circuit 200, such as the bias circuit of Figure 1. Each channel circuit 232 also includes a transmitter circuit 230 and a receiver circuit 231. As is known in the art, each of the transmitter circuit 230 and receiver circuit 231 includes one or more amplifiers, which can be cascodes and / or VGAs. The one or more amplifiers receive the differential voltage and / or the common-mode voltage from the bias circuit 200 associated with the channel circuit 232.

Each multi-channel amplifier circuit 234 also includes a temperature coefficient generator circuit, which is provided as part of the global bias circuit 233 in Figure 2. The temperature coefficient generator circuit provides the common-mode temperature coefficient (TC2) and the differential temperature coefficient (TC1) to each of the plurality of channel circuits 232, and in turn to each of the bias circuits 200. As discussed above, in some examples the bias circuit 200 uses the common-mode temperature coefficient (TC2) and the differential temperature coefficient (TC1) to set the voltage levels of the common-mode voltage and the differential voltage respectively.

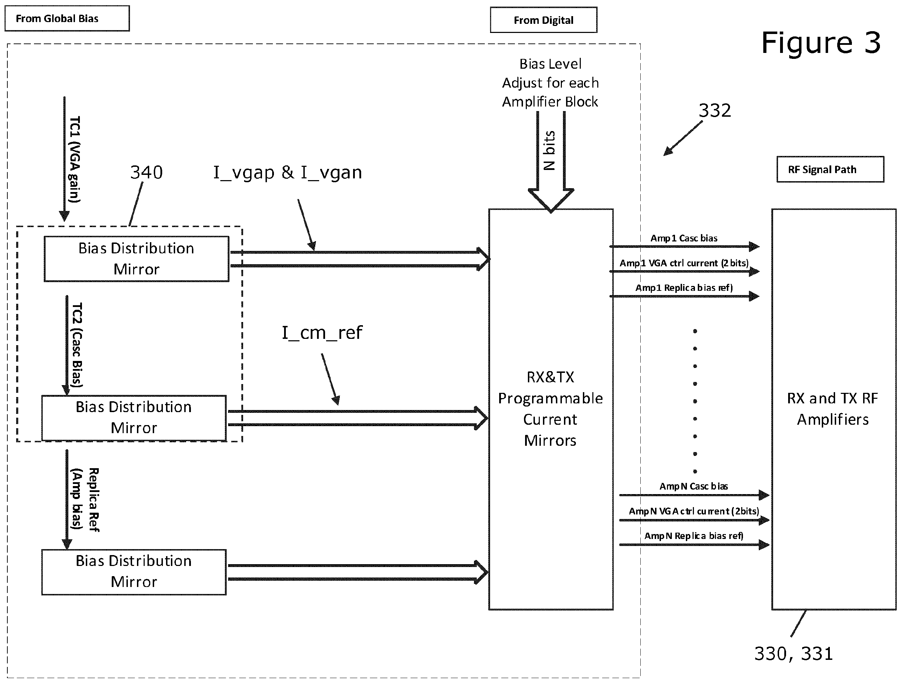

Figure 3 shows further details of a channel circuit 332 according to an embodiment of the present disclosure. The channel circuit 332 includes a bias circuit 300 that is configured to provide the same functionality as the bias circuit of Figure 1. The bias circuit 300 of Figure 3 also shows an example of a reference current generator circuit 340. The reference current generator circuit 340 of Figure 3 receives a common-mode temperature coefficient (TC2) and a differential temperature coefficient (TC1). As shown in Figure 3, the reference current generator circuit 340: provides the differential current (I_vgap & I_vgan) based on the differential temperature coefficient (TC1); and provides the common-mode reference current (I_cm_ref) (and therefore sets the common-mode current) based on the common-mode temperature coefficient (TC2). The amplifiers of the transmitter and receiver circuits are shown collectively with reference 330, 331 in Figure 3.

Returning to Figure 2, this drawing shows use of a central bias unit, such as the global bias circuit 233, to create reference currents for a 16-channel beamforming transceiver. The example of Figure 2 can save power and area by having a global bias block that provides temperature coefficients to a plurality of channel circuits 232. It can also simplify the design of the local bias blocks 200 and save design and layout time by using unit building blocks for the bias circuits 200. As discussed above, the currents that are used by the bias circuits 200 can have independently programmable temperature coefficients, which can allow gain and linearity over temperature to be optimized. In addition, the value of an amplifier bias can be adjusted to compensate for process variation. Such values can be determined at wafer sort testing and stored in Multi-Time Programmable (MTP) memory, for example.

Power dissipation and area can be extremely important for a chip of the size / complexity that is often used in beamforming applications. Beneficially, the examples disclosed herein can lower the overall power consumption. They can also simplify the top-level design and layout to save time and effort. A separate DC bias from RF path is provided to make top-level floor planning easier. Flexibility to perform process calibration globally for all blocks can also be provided. In addition, temperature behaviour of signal paths can be tailored by adjustable temperature coefficients.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/-methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A bias circuit configured to provide a differential voltage and a common-mode voltage, the bias circuit comprising:

   a first differential output terminal and a second differential output terminal, configured to provide the differential voltage therebetween;
   a common-mode output terminal, configured to provide the common-mode voltage;

   a differential circuit comprising:

   a first differential input terminal and a second differential input terminal, configured to receive a differential current therebetween;
   a first differential input resistor, a first differential output resistor, a second differential output resistor, and a second differential input resistor connected together in series, in that order, between the first differential input terminal and the second differential input terminal; wherein: i) the first differential output terminal is connected to a node between the first differential input resistor and the first differential output resistor; and the second differential output terminal is connected to a node between the second differential output resistor and the second differential input resistor;

   a common-mode circuit comprising:

   a common-mode biasing terminal that is connected to a node between the first differential output resistor and the second differential output resistor, wherein the common-mode biasing terminal is configured to receive a common-mode bias current;
   a common-mode transistor comprising:

   a conduction channel that is connected in series between:

   i) the node between the first differential output resistor and the second differential output resistor; and
   ii) a reference terminal; and

   a control terminal;

   a common-mode resistor that is connected between: i) the node between the first differential output resistor and the second differential output resistor; and ii) the control terminal of the common-mode transistor; and
   a common-mode current source connected between the control terminal of the common-mode transistor and the reference terminal;

   wherein the common-mode output terminal is connected to the node between the first differential output resistor and the second differential output resistor.

2. The bias circuit of claim 1, wherein the resistance levels of the first differential output resistor and the second differential output resistor are configurable in order to set the differential voltage between the first and second differential output terminals, without affecting the common-mode voltage at the common-mode output terminal.

3. The bias circuit of claim 1 or claim 2, wherein the resistance level of the common-mode resistor is configurable in order to set the common-mode voltage at the common-mode output terminal, without affecting the differential voltage between the first and second differential output terminals.

4. The bias circuit of any preceding claim, wherein the common-mode current source is configurable such that it provides a common-mode current in order to set the common-mode voltage at the common-mode output terminal, without affecting the differential voltage between the first and second differential output terminals.

5. The bias circuit of claim 4, wherein the common-mode current source provides the common-mode current at a level that is based on a common-mode temperature coefficient.

6. The bias circuit of claim 5, further comprising:
a reference current generator circuit, configured to: receive the common-mode temperature coefficient and provide the common-mode current based on the received common-mode temperature coefficient.

7. The bias circuit of claim 6, wherein the current source comprises a current mirror, wherein the current mirror receives a common-mode reference current as an input signal and provides the common-mode current as an output signal.

8. The bias circuit of claim 7, further comprising:
a reference current generator circuit, configured to: receive the common-mode temperature coefficient and provide the common-mode reference current based on the received common-mode temperature coefficient.

9. The bias circuit of any preceding claim, further comprising a differential current source that is configured to provide the differential current at a level that is based on a differential temperature coefficient.

10. The bias circuit of claim 9, further comprising:
a reference current generator circuit, configured to: receive the differential temperature coefficient and provide the differential current to the first and second differential input terminals based on the received differential temperature coefficient.

11. The bias circuit of any preceding claim, wherein the common-mode transistor is a bipolar transistor.

12. A multi-channel amplifier circuit, comprising:
a plurality of channel circuits, wherein each channel circuit comprises:

a bias circuit according to claim 1; and
one or more amplifiers, wherein the one or more amplifiers are configured to receive the differential voltage and the common-mode voltage from the associated bias circuit.

13. The multi-channel amplifier circuit of claim 12, wherein:

the common-mode current source provides a common-mode current at a level that is based on a common-mode temperature coefficient;

and wherein the multi-channel amplifier circuit further comprises:

a differential current source that is configured to provide the differential current to the first and second differential input terminals at a level that is based on a differential temperature coefficient; and
a temperature coefficient generator circuit that is configured to provide the common-mode temperature coefficient and the differential temperature coefficient to each of the plurality of channel circuits.

14. The multi-channel amplifier circuit of claim 12 or claim 13, wherein:

the multi-channel amplifier circuit comprises a beamforming circuit; and
each of the plurality of channel circuits corresponds to a different channel of the beamforming circuit.

15. The multi-channel amplifier circuit of claim 14, wherein each of the channel circuits of the beamforming circuit comprises a transceiver circuit configured to transmit and / or receive signalling.

# Figure 1

100

I_cm_bias

111

I_vgap

108

104

I_vgan

109

107

110

V_vgap

Rvga

101

Rvga

V_vgan

112

105

106

113

102

I_cm_ref

116

Rcm

103

V_cascode_cm

119

Q1

120

115

Ibias_Q1 = I_cm_bias

1:1

121

114

117

118

Figure 2

EP 4 734 365 A1

# Figure 3

Bias Level
Adjust for each
Amplifier Block

N bits

332

TC1 (VGA gain)

340

I_vgap & I_vgan

RF Signal Path

Bias Distribution
Mirror

Amp1 Casc bias

Amp1 VGA ctrl current (2 bits)

Amp1 Replica bias ref)

TC2 (Casc Bias)

I_cm_ref

RX&TX
Programmable
Current
Mirrors

RX and TX RF
Amplifiers

Bias Distribution
Mirror

Replica Ref
(Amp bias)

Amp N Casc bias

Amp N VGA ctrl current (2bits)

Amp N Replica bias ref)

Bias Distribution
Mirror

330, 331

EP 4 734 365 A1

11

Europäisches
Patentamt
European
Patent Office
Office européen
des brevets

# EUROPEAN SEARCH REPORT

**Application Number**

EP 24 20 8762

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 583 661 B1 (TANJI TODD M [US] ET AL) 24 June 2003 (2003-06-24) * figure 4 * | 1-15 | INV. H03F3/19 H03F3/24 H03F1/22 G05F3/26 H03F3/45 |
| A | US 2019/207558 A1 (MITTAL AYUSH [IN] ET AL) 4 July 2019 (2019-07-04) * paragraphs [0054] - [0061]; figure 5 * | 1-15 | |
| A | US 2024/235498 A9 (SHANGHAI WUQI MICROELECTRONICS CO LTD [CN]) 11 July 2024 (2024-07-11) * paragraphs [0051] - [0056]; figures 1,2 * | 1-15 | |

**TECHNICAL FIELDS SEARCHED (IPC)**

H03F
G05F

The present search report has been drawn up for all claims

| Place of search | Date of completion of the search | Examiner |
|---|---|---|
| The Hague | 14 March 2025 | Zakharian, Andre |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 20 8762

14-03-2025

| Patent document cited in search report | | Publication date | Patent family member(s) | | Publication date |
|---|---|---|---|---|---|
| US 6583661 | B1 | 24-06-2003 | NONE | | |
| US 2019207558 | A1 | 04-07-2019 | NONE | | |
| US 2024235498 | A9 | 11-07-2024 | CN | 117978101 A | 03-05-2024 |
| | | | EP | 4362327 A1 | 01-05-2024 |
| | | | JP | 7642693 B2 | 10-03-2025 |
| | | | JP | 2024062911 A | 10-05-2024 |
| | | | US | 2024136985 A1 | 25-04-2024 |

EPO FORM P0459